# FASCICULE DE BREVET EUROPEEN

(11) **EP 0 675 503 B1**
(45) Date de publication et mention de la délivrance du brevet: **06.10.1999**
(21) Numéro de dépôt: 95400608.6
(22) Date de dépôt: 20.03.1995
(51) Int. Cl.: G11C 16/06

(54) **Mémoire intégrée avec circuit de maintien de la tension de colonne**
Integrierter Speicher mit Spaltenspannungserhaltungsschaltung
Integrated memory with circuit to maintain column voltage

(30) Priorité: 31.03.1994 FR 9403844
(43) Date de publication de la demande: 04.10.1995
(73) Titulaire: STMicroelectronics S.A., 94250 Gentilly (FR)
(72) Inventeur: Rouy, Olivier, F-75116 Paris (FR)
(74) Mandataire: Ballot, Paul Denis Jacques

(56) Documents cités:
- EP-A- 0 525 679
- EP-A- 0 574 976
- WO-A-95/07536
- GB-A- 2 214 380
- US-A- 5 146 152

## Description

L'invention concerne les mémoires à semi-conducteurs de type intégré dont les cellules élémentaires de mémoire sont organisées en rangées et colonnes et, plus particulièrement dans de telles mémoires, un circuit pour maintenir constante la tension de la colonne lors de l'enregistrement.

Une mémoire à semi-conducteurs de type classique comprend, par exemple, 16 millions de cellules de mémoire environ (16 mégabits) qui sont organisées en 32 secteurs de 512.000 bits, chaque secteur contenant 64.000 mots de 8 bits chacun.

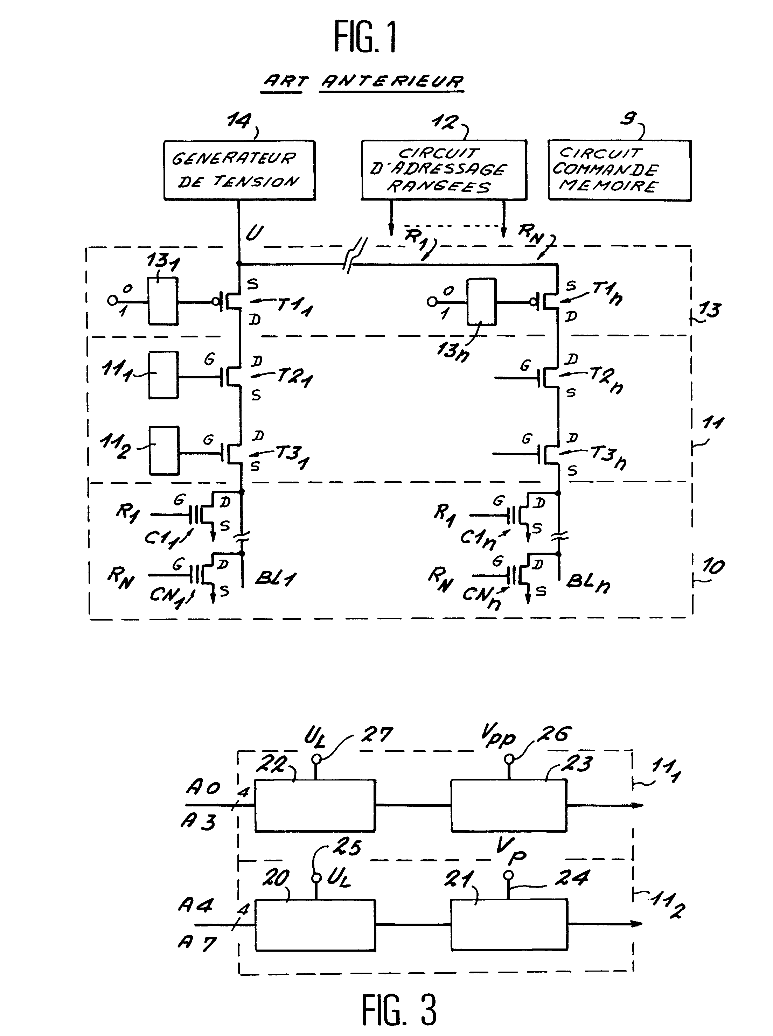

De manière schématique et à titre indicatif, une mémoire 10 intégrée , non-volatile, effaçable et programmable électriquement comprend (figure 1) des cellules de mémoire consistant chacune en un transistor MOSFET à grille flottante de type N, C1₁ à CN₁ pour la première colonne BL₁, également appelée ligne de bit, et C1ₙ à CNₙ pour la dernière colonne BLₙ. La sélection d'une cellule de mémoire qui est située à l'intersection d'une colonne et d'une rangée est effectuée par un circuit d'adressage 11 des colonnes et par un circuit d'adressage 12 des rangées. Pour chaque colonne, l'indication de la valeur binaire de l'information à enregistrer dans une cellule de mémoire est obtenue par un circuit de programmation 13. Les colonnes sont reliées à un générateur de tension 14 qui fournit une tension U.

Le circuit d'adressage 12 des rangées reçoit le code d'adresse d'une rangée et fournit l'un des signaux de sélection de rangée R₁ à R_{N} qui est appliqué à la grille G des transistors d'une même rangée.

Le circuit d'adressage 11 des colonnes comprend deux circuits de décodage 11₁ et 11₂ qui reçoivent chacun une partie du code d'adresse d'une colonne et fournissent chacun un signal de sélection d'une colonne qui est appliqué à la grille G d'un des transistors T2₁ à T2ₙ ou T3₁ à T3ₙ qui sont des transistors MOSFET de type N.

Le circuit de programmation 13 de la valeur binaire à enregistrer dans la cellule de mémoire comprend un transistor MOSFET de type P (T1₁ à T1ₙ) par colonne qui reçoit sur sa grille, par l'intermédiaire d'un circuit d'adaptation 13₁ à 13ₙ, la valeur binaire 0 ou 1.

Dans une colonne telle que BL₁, les transistors T1₁, T2₁, T3₁ sont en série tandis que les transistors C1₁ à CN₁ sont chacun en parallèle entre une colonne et une rangée, le drain étant connecté à la colonne et les sources de tous les transistors étant connectées à un circuit d'alimentation (non représenté).

Dans la mémoire qui vient d'être décrite succinctement en relation avec la figure 1, l'enregistrement des informations dans les cellules de mémoire est précédé d'une opération d'effacement de toutes les cellules de manière à les mettre dans un état déterminé, par exemple l'état 1 qui correspond à l'absence d'électrons dans la grille flottante du transistor de la cellule de mémoire. Pour l'enregistrement d'un mot, seules les cellules qui doivent enregistrer un état 0 seront sélectionnées pour leur appliquer simultanément une tension appropriée sur le drain (par exemple 5-7 volts) et sur la grille (par exemple 12 volts) alors que la source reste à zéro volt. La tension U est aiguillée vers les lignes de bit par le circuit d'adressage 11 des colonnes et le circuit de programmation 13.

Les différentes opérations qui sont effectuées dans la mémoire sont sous le contrôle des signaux fournis par un circuit de commande mémoire 9 qui est de tout type connu.

Dans un tel montage, des chutes de tension, dues aux résistances parasites et de transfert des transistors des circuits de programmation 13 et d'adressage 11, abaissent la tension qui est appliquée à la colonne BL. Il en résulte que la tension appliquée à la colonne BL est dépendante du courant dans la colonne.

WO-A-95/07536 cité conformément à l'article 54(3)(4), CBE, décrit une mémoire EPROM contenant un circuit de maintien de tension (50 dans la fig.4; 160 dans la fig.10) pour maintenir constante la tension de la ligne de bit (VDP) lorsque cette ligne de bit est sélectionnée pour effectuer l'enregistrement d'une valeur binaire. Dans ce document, ledit circuit de tension comprend un circuit de miroir de courant (161,165-167) et un transistor EPROM (169) pour générer ladite tension de ligne de bit (VDP). Il n'y est pas prévu d'amplificateur différentiel qui mesure la difference entre une tension de référence et une tension representative de la ligne de bit.

Le but de la présente invention est de réaliser une mémoire intégrée qui comprend un circuit permettant d'obtenir une tension sur la colonne BL sélectionnée pour l'enregistrement d'une valeur binaire qui est indépendante des chutes de tension aux bornes des transistors de programmation et de sélection.

Selon l'invention, une mémoire intégrée non volatile, effaçable et programmable électriquement, ladite mémoire étant organisée en rangées et colonnes de cellules de mémoire, lesdites rangées étant sélectionnées par des circuits d'adressage de rangée, lesdites colonnes ou lignes de bit étant sélectionnées par des circuits d'adressage de colonne chacun connectant une ligne de bit à une tension d'alimentation via un transistor de selection et un circuit de programmation de la valeur binaire à enregistrer, ladite mémoire comprenant un circuit de maintien de tension pour maintenir constante la tension de la ligne de bit à une valeur constante lorsque cette ligne de bit est sélectionnée pour effectuer l'enregistrement d'une valeur binaire.

Le circuit de maintien de tension comprend un amplificateur différentiel qui mesure la différence entre une tension de référence et une tension représentative de la ligne de bit et qui fournit un signal tendant à diminuer l'écart entre la tension de référence et la tension représentative, ledit signal étant appliqué à la grille du transistor de sélection de colonne sur la ligne de bit.

D'autres caractéristiques et avantages de la présente invention apparaîtront à la lecture de la description suivante d'un exemple particulier de réalisation, ladite description étant faite en relation avec les dessins joints dans lesquels :
- la figure 1 est un schéma fonctionnel d'une mémoire intégrée à semi-conducteurs, non volatile, effaçable et programmable électriquement selon l'art antérieur,
- la figure 2 est un schéma fonctionnel d'une mémoire intégrée comprenant un circuit selon l'invention, et
- la figure 3 est un schéma fonctionnel des circuits d'adressage des colonnes de la mémoire intégrée.

Dans les différentes figures, le mêmes références désignent les mêmes éléments dans des fonctions identiques.

La figure 1, qui correspond à l'art antérieur du préambule, ne sera pas décrite à nouveau mais fait partie intégrante de la description de l'invention.

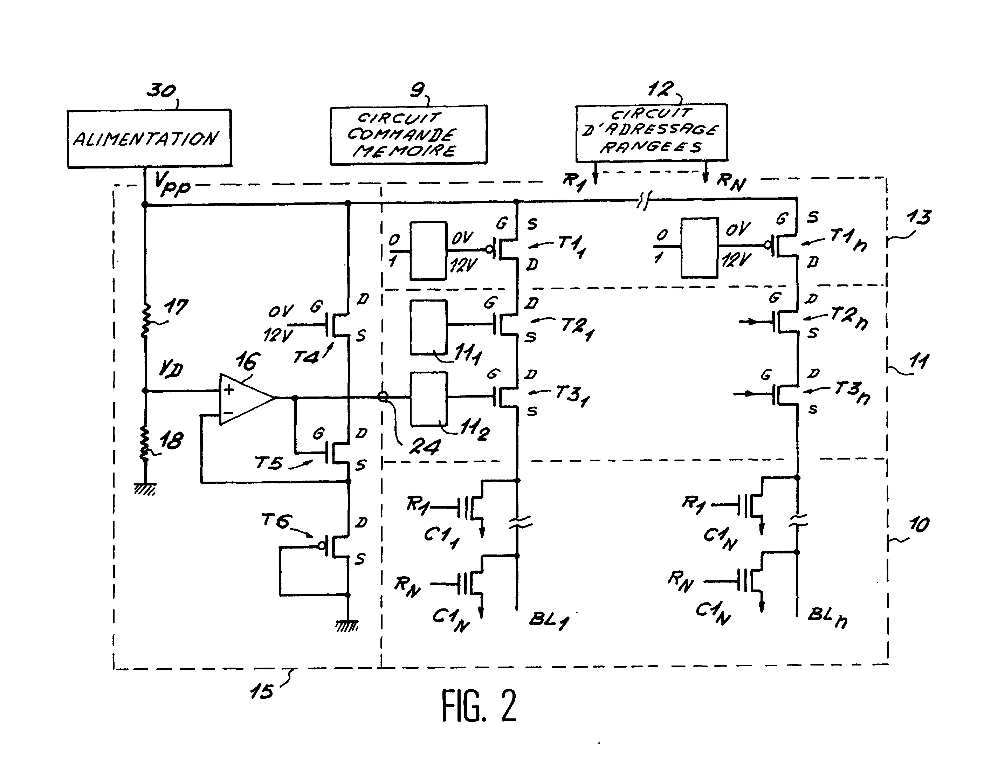

Le schéma de la figure 2, est identique à celui de la figure 1 sauf en ce qui concerne un élément 15 qui constitue le circuit selon l'invention.

Ce circuit comprend trois transistors T4, T5 et T6 qui sont connectés en série entre un potentiel Vₚₚ=12 volts, fourni par un dispositif d'alimentation 30, et la masse. Le premier transistor T4 de type N a son drain qui est connecté au potentiel Vₚₚ et sa source qui est connectée au drain du deuxième transistor T5. La grille du transistor T4 est connectée à un générateur de tension qui fournit une tension U = 12 volts, soit une tension de zéro volt, le choix étant réalisé par la programmation selon que la mémoire est en cycle d'enregistrement ou de lecture.

La source du deuxième transistor T5, de type N, est connectée au drain du troisième transistor T6, de type P, dont la source est connectée, d'une part, à la masse et d'autre part à la grille.

La source du transistor T5 est connectée à une entrée soustractive d'un amplificateur différentiel 16 dont l'autre entrée est connectée au point commun de deux résistances 17 et 18 en série entre le potentiel Vₚₚ et la masse. La sortie de l'amplificateur différentiel 16 est connectée d'une part à la grille du deuxième transistor T5 et à une entrée du circuit d'adressage 11₂ dont le transistor associé T3 est connecté directement à la colonne ou ligne de bit BL.

Comme le montre le schéma fonctionnel de la figure 3, le circuit d'adressage 11₂ comprend, de manière connue, un circuit de décodage 20 des chiffres A4 à A7 des adresses des colonnes qui sont appliqués sur ses entrées.

La sortie du circuit de décodage 20 est soit au niveau "zéro volt" soit au niveau logique U_{L} appliqué sur une borne d'entrée 25, par exemple 5 volts. Cette sortie est appliquée à un circuit élévateur de tension 21 qui fournit sur sa sortie soit le niveau "zéro volt", soit un niveau Vₚ qui est fourni par une borne d'entrée 24 alimentée à la tension Vₚ.

Le circuit d'adressage 11₁ est similaire au circuit d'adressage 11₂ sauf qu'il reçoit les chiffres A0 à A3 des adresses de colonnes sur les entrées d'un circuit de décodage 22 alimenté par une tension U_{L} sur une borne d'entrée 27 et que le niveau de sortie Vₚₚ de 12 volts est fourni par une borne d'entrée 26 alimentée à la tension Vₚₚ.

Selon l'invention, la borne de sortie de l'amplificateur différentiel est connectée à la borne d'entrée 24 du circuit élévateur de tension 21.

Le transistor T5 est identique au transistor T3 du circuit d'adressage 11. Le transistor T6 est choisi pour avoir une résistance de conduction qui est égale à celle de la ligne de bit dans le cas d'un transistor mémoire en état de programmation.

Le transistor T4 est conducteur durant le cycle d'enregistrement par sa tension de grille à U = 12 volts et est bloqué en dehors de ce cycle de manière à déconnecter le circuit selon l'invention quand il n'y a pas de cycle d'enregistrement.

Les valeurs des résistances 17 et 18 sont choisies pour que la tension d'entrée de référence de l'amplificateur différentiel 16 soit une tension V_{D} qui est souhaitée sur la source du transistor T3₁. Ainsi, l'amplificateur différentiel 16 compare la tension V_{D} à la tension V_{S} de la source du transistor T5 et modifie sa tension de sortie pour que la source de T5 soit à la tension Vₚ.

Il en résulte que la tension d'alimentation Vₚ sur la borne 24 reste constante et que la tension sur la ligne de bit BL est indépendante du courant dans les transistors T1 et T2.

Les différentes opérations à effectuer dans la mémoire sont commandées par le circuit de commande 9.

La tension de référence est égale à la tension de drain V_{D} à obtenir sur le drain du transistor de sélection T3 et est fournie par un diviseur de tension résistif.

La tension représentative de la ligne de bit est fournie par une résistance connectée à un générateur de courant T6, ladite résistance étant égale à celle de la ligne de bit lorsqu'une cellule est conductrice et le courant du générateur étant égal à celui circulant dans la ligne de bit lorsqu'une cellule est conductrice.

La tension représentative de la ligne de bit est fournie par un transistor image T6 dont la résistance de conduction est égale à celle de la ligne de bit lorsqu'une cellule est conductrice.

Le transistor image T6 est connecté en série avec un transistor suiveur T5 qui est identique au transistor de sélection T3 de colonne, et le transistor suiveur T5 ainsi que le transistor de sélection T3 de colonne sont montés en montage suiveur de manière que les grilles des deux transistors sont connectées à la borne de sortie de l'amplificateur différentiel 16.

Le drain du transistor suiveur T5 est connecté à la tension d'alimentation Vₚₚ par l'intermédiaire d'un transistor de commutation T4 qui n'est conducteur que pendant le cycle d'enregistrement de ladite mémoire 10 de sorte que le circuit de maintien 15 n'est actif que pendant ledit cycle d'enregistrement.

L'invention a été décrite avec des circuits d'adressage de colonne à deux niveaux mais elle est applicable au cas où il n'y a qu'un seul niveau d'adressage qui comprendrait le transistor T3 dans chaque colonne.

## Revendications

1. Mémoire intégrée (10) non volatile, effaçable et programmable électriquement, ladite mémoire (10) étant organisée en rangées et colonnes de cellules de mémoire, lesdites rangées étant sélectionnées par des circuits d'adressage de rangée (12), lesdites colonnes ou lignes de bit étant sélectionnées par des circuits d'adressage de colonne (11) chacun connectant une ligne de bit à une tension d'alimentation via un transistor de selection (T3) et un circuit de programmation (13) de la valeur binaire à enregistrer, caractérisée en ce que ladite mémoire (10) comprend un circuit (15) de maintien de tension pour maintenir constante la tension de la ligne de bit lorsque cette ligne de bit est sélectionnée pour effectuer l'enregistrement d'une valeur binaire, et en ce que le circuit de maintien de tension (15) comprend un amplificateur différentiel (16) qui mesure la différence entre une tension de référence et une tension représentative de la ligne de bit et qui fournit un signal tendant à diminuer l'écart entre la tension de référence et la tension représentative, ledit signal étant appliqué à la grille du transistor de sélection (T3) de colonne sur la ligne de bit.

2. Mémoire selon la revendication 1, caractérisée en ce que la tension de référence est égale à la tension de drain (V_{D}) à obtenir sur le drain du transistor de sélection (T3) et est fournie par un diviseur de tension résistif et en ce que la tension représentative de la ligne de bit est fournie par un générateur de courant (T6) dont la résistance interne est égale à celle de la ligne de bit lorsqu'une cellule est conductrice et le courant du générateur étant égal à celui circulant dans la ligne de bit lorsqu'une cellule est conductrice.

3. Mémoire selon la revendication 2, caractérisée en ce que le générateur de courant est un transitor image (T6) dont la résistance de conduction est égale à celle de la ligne de bit lorsqu'une cellule est conductrice.

4. Mémoire selon la revendication 3, caractérisée
- en ce que le transistor image (T6) est connecté en série avec un transistor suiveur (T5) qui est identique au transistor de sélection (T3) de colonne, et
- en ce que le transistor suiveur (T5) et le transistor de sélection (T3) de colonne sont montés en montage suiveur de manière que les grilles des deux transistors sont connectées à la borne de sortie de l'amplificateur différentiel (16).

5. Mémoire selon la revendication 4, caractérisée en ce que le drain du transistor suiveur (T5) est connecté à la tension d'alimentation (Vₚₚ) par l'intermédiaire d'un transistor de commutation (T4) qui n'est conducteur que pendant le cycle d'enregistrement de ladite mémoire (10) de sorte que le circuit de maintien (15) n'est actif que pendant ledit cycle d'enregistrement.

## Patentansprüche

1. Nichtflüchtiger, löschbarer und elektrisch programmierbarer integrierter Speicher (10), der in Zeilen und Spalten mit Speicherzellen organisiert ist, wobei die Zeilen über Zeilenadressierschaltungen (12) ausgewählt werden, die Spalten oder Bitleitungen über Spaltenadressierschaltungen (11) ausgewählt werden, von denen jede eine Bitleitung mit einer Versorgungsspannung über einen Auswahltransistor (T3) und einen Schaltkreis zum Programmieren (13) des zu speichernden binären Werts ausgewählt wird, dadurch gekennzeichnet, daß
der Speicher (10) einen Spannungshalteschaltkreis (15) zum Konstanthalten der Spannung der Bitleitung, wenn diese Bitleitung gewählt ist, aufweist, um die Speicherung eines binären Werts auszuführen, und daß die Spannungshalteschaltung (15) einen Differentialverstärker (16), der die Differenz zwischen einer Bezugsspannung und einer für die Bitleitungen repräsentativen Spannung mißt und ein Signal liefert, welches das Verhältnis zwischen der Bezugsspannung und der repräsentativen Spannung verringern kann, aufweist, wobei dieses Signal an das Gate des Auswahltransistors (T3) der Spalte auf der Bitleitung angelegt wird.

2. Speicher nach Anspruch 1, dadurch gekennzeichnet, daß
die Bezugsspannung gleich der Drainspannung (V_{D}) ist, die an dem Drain des Auswahltransistors (T3) erhalten wird, und über einen ohmschen Spannungsteiler vorgesehen wird, und daß die Spannung, die für die Bitleitung repräsentativ ist, von einem Stromerzeuger (T6) vorgesehen wird, dessen innerer Widerstand gleich dem der Bitleitung ist, wenn eine Zelle leitend, und daß der Strom des Erzeugers gleich dem ist, der in der Bitleitung fließt, wenn eine Zelle leitend ist.

3. Speicher nach Anspruch 2, dadurch gekennzeichnet, daß der Stromerzeuger ein Spiegeltransistor (T6) ist, dessen Leitwiderstand gleich dem der Bitleitung ist, wenn eine Zelle leitend ist.

4. Speicher nach Anspruch 3, dadurch gekennzeichnet, daß
der Spiegeltransistor (T6) in Reihe mit einem Folgetransistor (T5) verbunden ist, der zu dem Transistor zur Auswahl (T3) der Spalte identisch ist, und
der Folgetransistor (T5) und der Transistor zur Auswahl (T3) der Spalte in Folgeschaltung derart angeordnet sind, daß die Gates der beiden Transistoren mit dem Ausgangsanschluß des Differentialverstärkers (16) verbunden sind.

5. Speicher nach Anspruch 4, dadurch gekennzeichnet, daß
der Drain des Folgetransistors (T5) mit der Versorgungsspannung (V_{PP}) über einen Schalttransistor (T4) verbunden ist, der nur während des Schreibzyklus des Speichers (10) leitet, so daß der Halteschaltkreis (15) nur während dieses Schreibzyklus aktiv ist.

## Claims

1. An integrated electrically erasable programmable read-only memory (10), said memory (10) being organised in rows and columns of memory cells, said rows being selected by row addressing circuits (12), said columns or bit lines being selected by column addressing circuits (11), each connecting a bit line to a supply voltage via a selector transistor (T3), and a circuit for programming (13) the binary value to be recorded, characterised in that said memory (10) has a voltage-maintaining circuit (15) in order to keep the voltage of the bit line constant if this bit line is selected for recording a binary value and in that the voltage-maintaining circuit (15) has a differential amplifier (16) which measures the difference between a reference voltage and a voltage representative of the bit line and which supplies a signal tending to decrease the difference between the reference voltage and the representative voltage, said signal being applied to the gate of the transistor (T3) for selecting the column on the bit line.

2. A memory as claimed in claim 1, characterised in that the reference voltage is equal to the drain voltage (V_{D}) to be obtained on the drain of the selector transistor (T3) and is supplied by a resistive voltage divider and in that the voltage representative of the bit line is supplied by a current generator (T6), the internal resistance of which is equal to that of the bit line if the cell is conducting and the generator current being equal to that circulating in the bit line if a cell is conducting.

3. A memory as claimed in claim 2, characterised in that the current generator is an image transistor (T6), the conduction resistance of which is equal to that of the bit line if a cell is conducting.

4. A memory as claimed in claim 3, characterised in that
- the image transistor (T6) is connected in series with a tracker transistor (T5) which is identical to the column selection transistor (T3) and
- in that the tracker transistor (T5) and the column selection transistor (T3) are connected in a tracker assembly so that the gates of the two transistors are connected to the output terminal of the differential amplifier (16).

5. A memory as claimed in claim 4, characterised in that the drain of the tracker transistor (T5) is connected to the supply voltage (V_{PP}) via a switching transistor (T4) which conducts only during the recording cycle of said memory (10) so that the maintaining circuit (15) is active only during said recording cycle.
